(19)

Europäisches
Patentamt
European
Patent Office
Office européen
des brevets

(11)  **EP 4 187 321 A1**

(12)  **EUROPEAN PATENT APPLICATION**

(43) Date of publication:
**31.05.2023  Bulletin 2023/22**

(21) Application number: **21210123.2**

(22) Date of filing: **24.11.2021**

(51) International Patent Classification (IPC):
**G03F 7/20** $^{(2006.01)}$

(52) Cooperative Patent Classification (CPC):
**G03F 7/70633; G03F 7/70641**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **ZHOU, Zili**
  **5500 AH Veldhoven (NL)**
• **SWINKELS, Daan**
  **5500 AH Veldhoven (NL)**
• **LIAN, Jin**
  **5500 AH Veldhoven (NL)**

(74) Representative: **ASML Netherlands B.V.**
**Corporate Intellectual Property**
**P.O. Box 324**
**5500 AH Veldhoven (NL)**

(54)  **METROLOGY METHOD AND ASSOCIATED METROLOGY TOOL**

(57)    Disclosed is a method of measuring an overlay or focus parameter from a target and associated metrology apparatus. The method comprises configuring measurement radiation to obtain a configured measurement spectrum of said measurement radiation by: imposing an intensity weighting on individual wavelength bands of said measurement radiation such that said individual wavelength bands have an intensity according to said intensity weighting, the intensity weighting being such that a measured value for the overlay or focus parameter is at least partially corrected for the effect of target imperfections; and/or imposing a modulation on a measurement spectrum of said measurement radiation. The configured measurement radiation is used to measure the target. A value for the overlay or focus parameter is determined from scattered radiation resultant from measurement of the target.

Fig. 6

**Description**

FIELD

The present invention relates to metrology applications and in particular to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

During the manufacturing process there is a need to inspect the manufactured structures and/or to measure characteristics of the manufactured structures. Suitable inspection and metrology apparatuses are known, which include e.g., spectroscopic scatterometers and angularly resolved scatterometers. Spectroscopic scatterometers may direct a broadband radiation beam onto the substrate and measure the spectrum (intensity as a function of wavelength) of the radiation scattered into a particular narrow angular range. Angularly resolved scatterometers may use a monochromatic radiation beam and measure the intensity of the scattered radiation as a function of angle.

In some metrology applications, such as those using scatterometers, imperfections in metrology targets can result in a wavelength/polarization dependent variation in a measured value from that target. As such, correction and/or mitigation for this variation is sometimes effected by performing the same measurement using multiple different wavelengths and/or polarizations (or more generally, multiple different illumination conditions). These multiple wavelength measurements are typically performed sequentially and therefore incur an associated throughput penalty. It would be desirable to improve one or more aspects of measuring using multiple illumination conditions.

SUMMARY

In a first aspect of the invention, there is provided a method of measuring an overlay or focus parameter from a target, the method comprising: configuring measurement radiation to obtain a configured measurement spectrum of said measurement radiation by:

imposing an intensity weighting on individual wavelength bands of said measurement radiation such that said individual wavelength bands have an intensity according to said intensity weighting,
the intensity weighting being such that a measured value for the overlay or focus parameter is at least partially corrected for the effect of target imperfections (e.g., including asymmetric and
symmetric imperfections); and/or
imposing a modulation on a measurement spectrum of said measurement radiation;

measuring the target with said configured measurement radiation and capturing resultant scattered radiation from the target; and

determining a value for said overlay or focus parameter from said scattered radiation.

In a second aspect of the invention, there is provided a metrology apparatus measuring an overlay or focus parameter from a target, being operable to perform the method of the first aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a dark field and/or bright-field microscope according to embodiments of the invention;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay (DBO) measurements and (d) a third pair of illumination apertures combining the first and second pair of apertures
- Figure 6 is a flow diagram describing a calibration phase of a method according to an embodiment of the invention;
- Figure 7 is a flow diagram describing a metrology method during a manufacturing phase according to an embodiment of the invention;
- Figure 8 is a schematic drawing of a suitable fast color switching illumination arrangement usable in embodiments of the invention; and
- Figure 9 comprise a plot of (a) a first illumination spectrum and (b) the corresponding temporal coherence function for the first illumination spectrum; (c) a second illumination spectrum and (d) the corresponding temporal coherence function for the second illumination spectrum; (e) a third illumination spectrum and (f) the corresponding temporal coherence function for the third illumination spectrum.

DETAILLED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

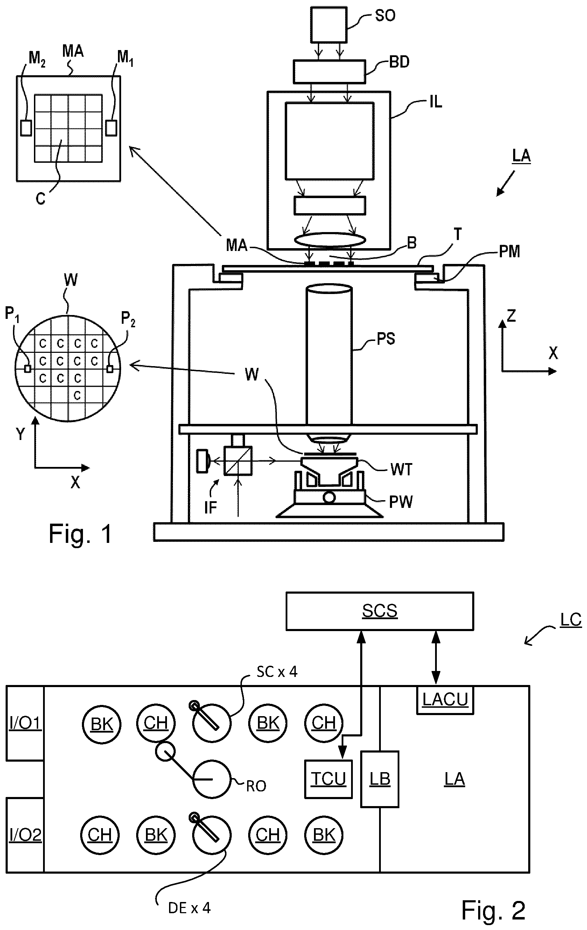

Figure 1 schematically depicts a lithographic apparatus LA. The lithographic apparatus LA includes an illumination system (also referred to as illuminator) ILL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system ILL receives a radiation beam from a radiation source SO, e.g. via a beam delivery system BD. The illumination system ILL may include various types of optical components, such as refractive, reflective, magnetic, electromagnetic, electrostatic, and/or other types of optical components, or any combination thereof, for directing, shaping, and/or controlling radiation. The illuminator ILL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

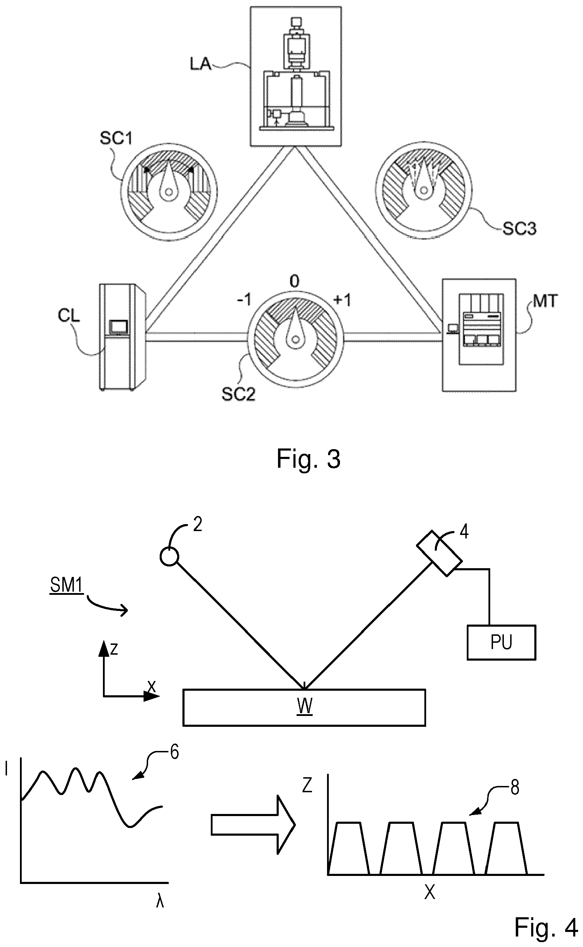

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

In order to monitor the lithographic process, parameters of the patterned substrate are measured. Parameters may include, for example, the overlay error between successive layers formed in or on the patterned substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured.

Examples of known scatterometers include angle-resolved scatterometers of the type described in US2006033921A1 and US2010201963A1. The targets used by such scatterometers are relatively large, e.g., 40$\mu$m by 40$\mu$m, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In a diffraction-based dark field metrology device, a beam of radiation is directed onto a metrology target and one or more properties of the scattered radiation are measured so as to determine a property of interest of the target. The properties of the scattered radiation may comprise, for example, intensity at a single scattering angle (e.g., as a function of wavelength) or intensity at one or more wavelengths as a function of scattering angle.

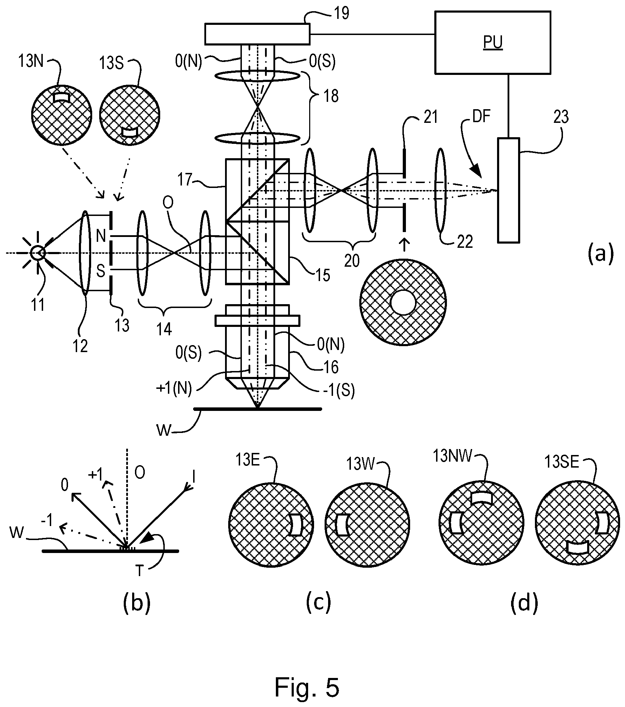

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least one of the first orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above

Measurement of targets in dark field metrology may comprise, for example, measuring the a first intensity of the 1st diffraction order $I_{+1}$ and a second intensity of the -1st diffraction order ($I_{-1}$) and calculating an intensity asymmetry ($A = I_{+1} - I_{-1}$), which is indicative of asymmetry in the target. The metrology targets may comprise one or more grating structures from which a parameter of interest may be inferred from such intensity asymmetry measurements, e.g., the targets are designed such that the asymmetry in the target varies with the parameter of interest. For example, in overlay metrology a target may comprise at least one composite grating formed by at least a pair of overlapping sub-gratings that are patterned in different layers of the semiconductor device. Asymmetry of the target will therefore be dependent on alignment of the two layers and therefore overlay. Other targets may be formed with structures which are exposed with different degrees of variation based on the focus setting used during the exposure; the measurement of which enabling that focus setting to be inferred back (again through intensity asymmetry).

When measuring a target, for example to measure an overlay or focus parameter (the latter being the focus setting used to expose the measured target), unwanted contributions from the target affect the measurement signal which have an impact on the measured overlay/focus value. Such unwanted contributions may be due to target imperfections such as unwanted target asymmetries other than those relating to the wanted overlay or focus parameter and/or symmetrical target imperfections. In an ideal situation, all wavelengths used in a multi-wavelength measurement would produce the same overlay value for a target on a geometrically perfect substrate. The effect of the unwanted contributions is a wavelength dependent measured asymmetry and therefore a wavelength dependent measured overlay variation, such that different colors yield different overlay values for a real (i.e., non-perfect) target and/or real (i.e., non-perfect) substrate. Such contributions or target imperfections may comprise, for example: unwanted grating asymmetry, for example in the form of floor tilt in the bottom grating or unequal side wall angles; thickness variation and sensor aberrations (layer thickness variation and interference within a stack can redistribute light within the pupil, which in combination with sensor aberrations causes wavelength dependent measured overlay variation); and residual topography and surface roughness.

It is now understood that multiple wavelength metrology can improve overlay measurement performance. As accuracy requirements for overlay metrology continue to become more stringent, one way of addressing this is to measure using more wavelengths. In present multi-wavelength overlay metrology, overlay images at different wavelengths are detected sequentially, and therefore increasing the number of wavelengths will incur a throughput penalty.

To address this, a method is proposed which combines color-multiplexing and weighting in overlay (or other parameter of interest) metrology. In an embodiment, the overlay metrology may be based on micro-diffraction based overlay (μDBO) principles. In μDBO, overlay is determined from the intensity difference of corresponding or complementary higher diffraction orders (for example the +1 and -1 diffraction orders). These diffraction orders may be imaged in an image plane (e.g., a dark-field image where the zeroth order is blocked before the image plane), and the intensities averaged over a region of interest (ROI) within each image of a diffraction order.

Present μDBO overlay metrology typically requires two targets (per direction) with imposed overlay biases, to enable a self-calibrated overlay measurement. However, in an embodiment, the methods disclosed herein enable (e.g., self-calibrated) measurement on a single (e.g., unbiased) target per direction.

According well-known μDBO theory, the intensity difference between ±1st orders, typically referred to as the intensity asymmetry $A_{\lambda_i}$, at a wavelength $\lambda_i$, can be written as:

$$A_{\lambda_i} = K_{\lambda_i} \cdot OV + k_{\lambda_i} \cdot N \qquad (1)$$

where $K_{\lambda_i}$ is the sensitivity of the real overlay at wavelength $\lambda_i$, and $k_{\lambda_i}$ is the sensitivity of nuisance parameters N, e.g., non-overlay asymmetries such as grating asymmetry, etc.. The nuisance term induces overlay errors and should be corrected.

It is proposed herein to perform a measurement using a combined plurality n of weighted wavelengths (i.e., a measurement using n wavelengths, suitable weighted, simultaneously). As a result of such a measurement, captured on the detector will be an image comprising a combination of n weighted intensity signals, from which the weighted intensity asymmetry $u_{\lambda i} \cdot A_{\lambda i}$ can be determined:

$$\sum_{i=1}^{n} u_{\lambda_i} \cdot A_{\lambda_i} = \sum_{i=1}^{n} u_{\lambda_i} \cdot K_{\lambda_i} \cdot OV + \sum_{i=1}^{n} u_{\lambda_i} \cdot k_{\lambda_i} \cdot N \qquad (2)$$

where $u_{\lambda i}$ is a weighting factor for wavelength $\lambda_i$. With the weighting factors properly chosen across the *n* wavelengths, the nuisance term in Equation (2) can be minimized (ideally eliminated), such that:

$$\sum_{i=1}^{n} u_{\lambda_i} \cdot k_{\lambda_i} \cdot N = 0 \qquad (3)$$

And therefore the real overlay value *OV* can be determined by:

$$OV = \sum_{i=1}^{n} \left( \frac{u_{\lambda_i}}{\sum_{i=1}^{n} u_{\lambda_i} \cdot K_{\lambda_i}} \cdot A_{\lambda_i} \right) \qquad (4)$$

For simplicity, based on Equation (4) a new weighting factor $w_{\lambda i}$ may be defined as:

$$w_{\lambda_i} = \frac{u_{\lambda_i}}{\sum_{i=1}^{n} u_{\lambda_i} \cdot K_{\lambda_i}} \qquad (5)$$

Therefore:

$$OV = \sum_{i=1}^{n} \left( w_{\lambda_i} \cdot A_{\lambda_i} \right) \qquad (6)$$

Equation 6 means that the real or corrected overlay value can be determined from mixed intensity signals $A_{\lambda i}$, and said previously determined weights $w_{\lambda i}$.

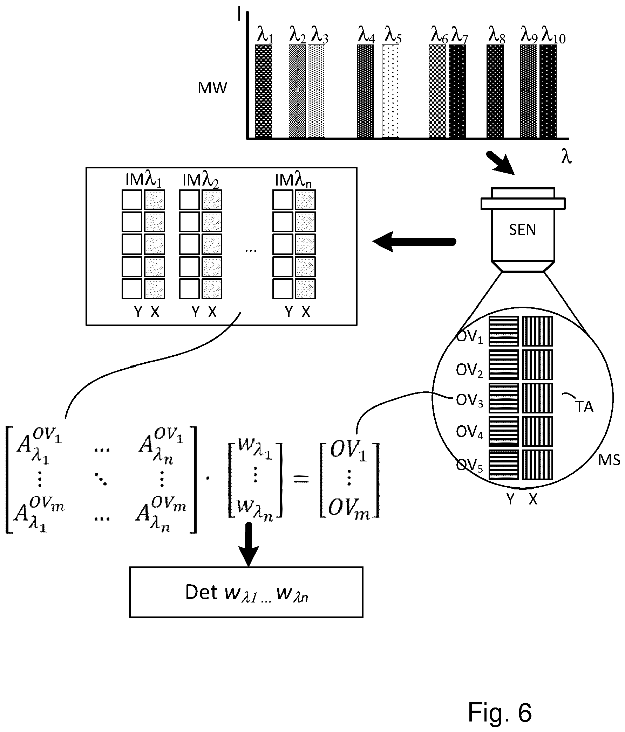

Figure 6 is a flow diagram illustrating how the weighting $w_{\lambda i}$ may be determined, e.g., in an initial or calibration phase. A target array TA is exposed on a wafer comprising (e.g., per direction in the substrate plane) a plurality of calibration targets having different set overlays $OV_1 ... OV_m$. In the example shown, 5 calibration targets per direction are comprised in the target array TA. In an embodiment, the set overlays. By way of a specific example, the 5 overlay biases $OV_1...OV_5$ may be e.g., -10nm, -5nm, 0nm, 5nm, 10 nm, although the actual set overlay values are not important (and do not need to be +/- pairs and a zero target as per this example. In principle any set overlay values can be used provided there is some diversity in their values. The plurality of targets do not necessarily need to be grouped together on the target in a target array TA as shown; however this is preferred to minimize any differences between targets other than the set overlays.

The calibration targets preferably should have a good similarity with the targets to be measured in the production phase. In other words, the calibration targets and production targets should be of the same type of design (e.g., similar pitch etc.) with a similar type and magnitude of imperfections (e.g. grating asymmetry, thickness variation, etc.). As such, the calibration targets may be representative of the production targets.

These targets are measured using multiple wavelengths as represented by the measurement wavelength MW plot. Here the measurement wavelengths MW are shown as comprising 10 distinct wavelength bands $\lambda_1$-$\lambda_{10}$, although the number of wavelength bands and their bandwidths may be varied, e.g., depending on the metrology sensor SEN and/or illumination source used. In an embodiment, the number of wavelength bands may be more than 2, more than 3, more than 5, more than 8 or more than 10 for example. In this calibration, the target array may be measured by each of these wavelengths sequentially. Of note is that the wavelengths are not weighted such that each comprises the same intensity I. Although the full target array TA is shown within measurement spot MS of the sensor SEN, this does not need to be the case, and the targets may be measured individually, or any subset of the target array TA at a time.

Once the targets are measured and the $\pm$1st order intensities detected from the resultant images $IM\lambda_1$-$IM\lambda_n$, the intensity asymmetries of the targets can be calculated for the n selected wavelengths (here 10 wavelengths), using the methods described. Assuming there are in total m set overlay values, the measured intensity asymmetries can be written as:

$$\begin{bmatrix} A_{\lambda_1}^{OV_1} & \cdots & A_{\lambda_n}^{OV_1} \\ \vdots & \ddots & \vdots \\ A_{\lambda_1}^{OV_m} & \cdots & A_{\lambda_n}^{OV_m} \end{bmatrix} \cdot \begin{bmatrix} w_{\lambda_1} \\ \vdots \\ w_{\lambda_n} \end{bmatrix} = \begin{bmatrix} OV_1 \\ \vdots \\ OV_m \end{bmatrix} \qquad (7)$$

In Equation 7, the overlay values *OV* are known from the set overlays and the asymmetries *A* are known from measurement. In a final step DET $w_{\lambda 1}$ ... $w_{\lambda n}$ the value of the weighting vector $w_{\lambda i}$ is determined. This may be done by any suitable regression method, including linear regression, partial least square regression, or any other suitable method such as independent component analysis, a machine learning method or any other method.

The determined weighting vector $w_{\lambda i}$ can then be used to configure a measurement spectrum or illumination spectrum for measurement of a target using multiple wavelengths simultaneously, each wavelength having an intensity according to said weighting vector. The wavelength bands should be the same as used in the calibration phase. As such, the weighting of the wavelengths comprised within a single capture or measurement is achieved by weighting the intensities for each of the wavelengths. In this way, overlay may be measured more accurately, and from unbiased targets (e.g., a single target per direction) using the configured measurement spectrum in a production or high volume manufacturing (HVM) phase.

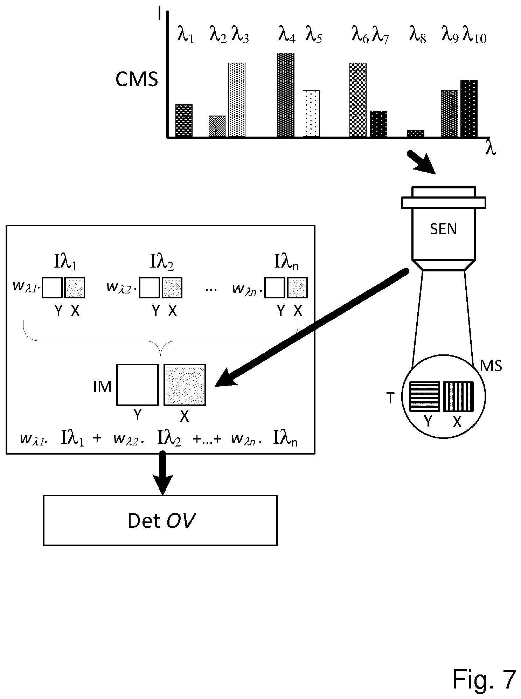

Figure 7 is a flow diagram illustrating how overlay may be determined in such an embodiment. A target T (e.g., here comprising an X pad (sub-target) and a Y pad (sub-target)) is measured within a measurements spot MS of a metrology sensor SEN. The target may comprise zero bias, and may have only one pad/grating/sub-target, or only one pad/grating/sub-target per direction. Such unbiased μDBO targets will occupy approximately half of the area compared with standard biased μDBO typically used presently.

The measurement radiation has a configured measurement spectrum CMS, in which the intensity of each respective wavelength band is weighted according to the weighting $w_{\lambda i}$ determined in the calibration phase (i.e., the intensity of a particular wavelength band will be lower if its respective weight is lower). A suitably shaped/weighted spectrum can be provided by a fast color switcher such as will be described later, or an acousto-optical tunable filter AOTF in the illumination branch. The $\pm$1st order μDBO image(s) IM of the target T (the two diffraction orders may be imaged simultaneously or sequentially) is detected. The image IM comprises all of the weighted component wavelengths combined, as conceptually illustrated in the drawing. Finally, the intensity asymmetries $\boldsymbol{A}_{\lambda}i$ are determined from the intensities, per wavelength, of the image (e.g., the intensities for each wavelength may be determined from the image). Finally, the overlay is determined Det *OV* from the intensity asymmetries $\boldsymbol{A}_{\lambda i}$, e.g., using Equation 6. It should be appreciated that the measurement step may comprise two measurements, e.g., if both positive and negative weights are determined in the calibration stage. If so, the measurements may be split between the positive weighted wavelengths and negative weighted wavelengths; i.e., comprise a first measurement for the one or more of said wavelengths which were assigned with positive weights, and a second measurement for the one or more of said wavelengths which were assigned with negative weights. The basic concept of this split measurement is described in WO2021/001102, which is incorporated herein by reference. In such an embodiment, a first measurement may comprise measuring a first intensity asymmetry $A_{\lambda i}^{pos}$ using a combination of all the wavelengths assigned with positive weights $w_{\lambda i}^{pos}$; i.e.:

$$\sum_{i=1}^{n1} \left( w_{\lambda_i}^{pos} \cdot A_{\lambda_i}^{pos} \right) \qquad (8)$$

and the second measurement may comprise measuring a second intensity asymmetry $A_{\lambda i}^{neg}$ using a combination of all the wavelengths assigned with negative weights $w_{\lambda i}^{neg}$; i.e., :

$$\sum_{i=1}^{n-n1} \left( \left| w_{\lambda_i}^{neg} \right| \cdot A_{\lambda_i}^{neg} \right) \qquad (9)$$

of course, it is not possible to measure negative intensities, and therefore the magnitude of the negative weights $\left| w_{\lambda_i}^{neg} \right|$ I is used to perform this measurement. Finally, Equation (6) may now take the form:

$$OV = \sum_{i=1}^{n} \left( w_{\lambda_i} \cdot A_{\lambda_i} \right) = \sum_{i=1}^{n1} \left( w_{\lambda_i}^{pos} \cdot A_{\lambda_i}^{pos} \right) - \sum_{i=1}^{n-n1} \left( \left| w_{\lambda_i}^{neg} \right| \cdot A_{\lambda_t}^{neg} \right) \qquad (10)$$

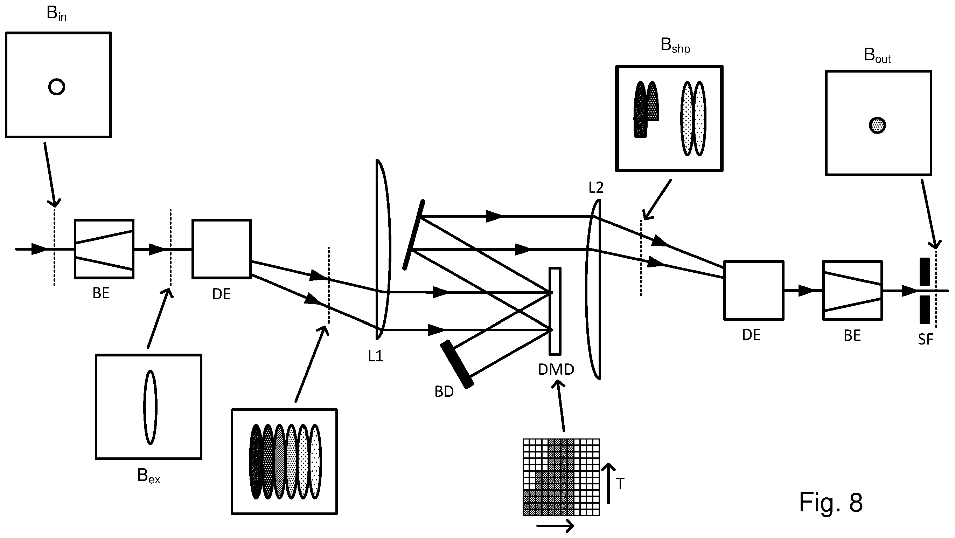

Figure 8 is a schematic drawing of a suitable fast color switching illumination arrangement suitable for obtaining the configured measurement spectrum which implements the determined weighting. The illumination arrangement is able to provide a tunable central frequency and bandwidth of color bands, simultaneous switching of multiple bands and tunable transmission per color band. The illumination arrangement may comprise a beam expanding (or smearing) optical element, such as a (first) 1D beam expander, (first) beam dispersing element (e.g., a prism of grating) and a DMD. The beam expanding optical element is operable to enable the DMD to modulate the color and transmission (per color) of the dispersed illumination radiation. The modulated beam is subsequently combined e.g., using a second beam expanding optical element and second dispersing element in opposite configuration. A single mode spatial filter may be provided at the output to facilitate wavefront shaping of the transmission per color, while maintaining a single mode output and full transmission control (e.g. from 0-100%).

In an embodiment, the 1D beam expander expands the beam in a first direction and the dispersing element disperses the expanded beam in a second direction. The first direction may be substantially perpendicular to the second direction. In such a manner, the DMD (comprising a 2D array of micromirrors or pixels) is able to select color on one axis of the 2D array and transmission per color on the other axis of the 2D array. While such an arrangement is practical in terms of control, more complicated expanding and dispersive element arrangements (other than a 1D beam expander which is orthogonally oriented with respect to the dispersive element) are possible within the scope of this embodiment. Such arrangements are possible provided that it is known which wavelength is controlled by each DMD pixel/micromirror.

A multiple wavelength (e.g., white light or broadband) input beam $B_{in}$ is expanded or spatially smeared in a first direction by beam expanding element BE (e.g., a 1D beam expanded) to obtain expanded beam $B_{ex}$. The 1D beam expander may, for example, comprise two cylindrical lenses/mirrors. The expanded beam $B_{ex}$ is dispersed by beam dispersing element DE (e.g., a prism or grating) to obtain dispersed (and expanded) beam $B_{dis}$. Note that in this embodiment the direction of dispersal by dispersing element DE is perpendicular to the expansion direction of the (e.g., 1D) beam expanding element BE. This is best understood by the Figure showing a cross section of the illumination beams $B_{in}$, $B_{ex}$ and $B_{dis}$ at the dotted lines at each stage of the arrangement. Note that the different shades of the different regions of the cross section of the dispersed beam $B_{dis}$ signify different colors/wavelengths and not intensities.

A DMD at a pupil plane of lens system L1, L2 is used to select colors and control the transmission of the dispersed beam $B_{dis}$. In this example, a first axis $\lambda$ selects the colors (e.g., bands and/or bandwidth), while the second axis T sees the same spectrum, but switching pixels on this axis controls the transmission (e.g., per color or color band). A cross section of the DMD is shown in the Figure with a purely exemplary transmission pattern, where shaded pixels illustrate "off pixels" (i.e., oriented to reflect illumination to beam dump BD) and non-shaded pixels illustrate "on pixels" (i.e., oriented to reflect illumination to the output). The resulting shaped beam $B_{shp}$ is recombined via second beam expanding element BE and second dispersing element DE. It can be seen here that the pattern on the DMD has completely blocked (switched off) the two central wavelength bands (of the six bands of dispersed beam $B_{dis}$), attenuated transmission of the leftmost two wavelength bands to differing degrees, while the rightmost two wavelength bands are unattenuated. The combined beam may then be projected onto a single-mode spatial filter SF (e.g., a pinhole or single-mode fiber, etc.), to provide an output beam $B_{out}$ with a fully controlled spectrum. If multimode input/output light is used, the spatial filter SF at the output may comprise a multimode filter (e.g., an iris or multimode fiber).

The transmission axis T on the DMD may be used for wavefront shaping per color to optimize transmission through the pinhole per color. A full dynamic range control from 0 to 100 % may be possible. The presented configuration is a transmission configuration. Of course, reflective configurations are also possible, so as to minimize absorption by the optical elements.

A second main embodiment will be described which comprises a method that allows the use of a broadband measurement spectrum to measure overlay on thick stacks. By appropriate modulation of the broadband measurement spectrum, a finite coherence time window may be created which is optimized for the overlay signal relating to a particular depth in the stack, and filters out noise from layers that are outside the window. In this way, an increase in the signal to noise ratio can be obtained.

In μDBO and/or DBO metrology, the overlay signal is generated via the interference between the top and bottom gratings (two structures of interest). When the stack thickness is large, the optical path length difference between the wave generated by the top grating and that generated by the bottom grating is also large. If the temporal coherence length is smaller than this path length difference, there will be no interference signal. The measurement depth D is dependent on the temporal coherence time of the light t according to:

$$D = c \cdot \frac{t}{2} \qquad (11)$$

where c is the speed of light.

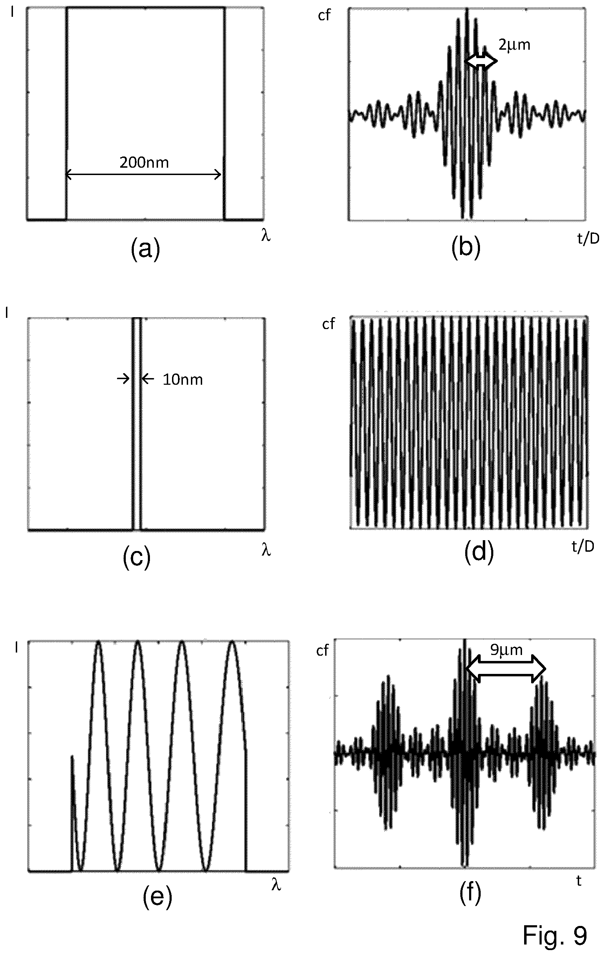

Temporal coherence can be characterized by the coherence function of the source. Figure 9(a) illustrates a measurement spectrum (intensity I against wavelength λ) comprising a flat 200 nm bandwidth source spectrum (e.g., with a center frequency of 788 nm). Figure 9(b) shows the corresponding temporal coherence function cf. Note that the temporal coherence function is shown plotted against depth D as well as time t or as the two are related by a constant according to Equation (11) and therefore the horizontal axis can also be scaled as a depth (D) axis. As such, it is possible to define a preferred measurement depth window corresponding to a certain depth. If the bandwidth of the measurement spectrum is 10 nm, as illustrated in Figure 9(c), its temporal coherence function changes, as shown in Figure 9(d).

Coherence is characterized by the visibility of the fringes of the coherence function. It can be seen that the visibility of the fringes using a 10 nm narrow source changes very little as the stack thickness D increases, whereas the visibility of the 200nm wide source drops very fast. As can be seen in Figure 9(b), this visibility drops sharply after D > 2μm, which means that, if using a measurement spectrum as illustrated in Figure 9(a), it is not possible to measure overlay on a target thicker than 2μm.

A broad spectrum does not necessarily need to be flat, and instead may be modulated. For example, a sinusoid-like modulation can be applied to the measurement spectrum. However, this is only an example and any spectral modulation may influence the temporal coherence. An example as to how such a modulation may be used is shown in Figures 9(e) and 9(f). Figure 9(e) shows a sinusoidal-like modulated measurement spectrum. This modulated spectrum results in the generation of two side 'wave-packets' having reasonable visibility in the temporal coherence function, as illustrated in Figure 9(f). The side wave packet in this case is centered around D = 9μm, which means that overlay may be measured for a stack which is ~ 9μm thick using such a measurement spectrum, even though the full spectrum extends over 200 nm.

Based on this, it can be appreciated that the input spectrum may be tailored or optimized, so as to optimize the coherence function for the stack thickness. For example, by shaping the spectrum it is possible to control which layers any interference between gratings occurs. This can potentially improve overlay robustness. For example, the measurement depth of D can be tuned by changing the modulation frequency of the spectrum. This enables measuring overlay at any depth of interest.

For example, it can be shown that the temporal coherence function is dependent on the period of a sinusoidal modulation of the measurement spectrum. As such, by adjusting this period it is possible to optimize the temporal coherence function for a particular time window (or depth window) comprising a particular depth D between layers or parts thereof (e.g., between the top layer and the top of the bottom layer). Other options include using different modulation functions than a sinusoidal modulation.

The shape of the time (depth) window can be further optimized by fine tuning the shape of the illumination spectrum.

The modulation of the spectrum can be performed, for example, by using an acousto-optical tunable filter AOTF or inserting a Fabray Perrot cavity into the illumination branch of a metrology apparatus such as that illustrated in Figure 5.

The concept of the second embodiment (temporal coherence function optimization for stack thickness) may be implemented individually to that of the first embodiment (weighted measurement spectrum), or the two concepts may be implemented together (e.g., a weighted measurement spectrum with addition modulation to optimize the temporal coherence function).

As such, the embodiments described above describe performing a measurement with multiple wavelengths simultaneously, using a configured measurement spectrum. As the multiple wavelengths are acquired simultaneously, a much higher throughput in multi-wavelength overlay detection is possible (e.g., in HVM) compared to sequential wavelength detection. The simultaneous measurements may be integrated on a single detector, and as such a detector per color is not required. Such a method may result in considerably better overlay performance (accuracy, robustness) than present methods. In addition, the approaches are compatible with current μDBO metrology sensor design. Also, at least for the first embodiment, unbiased µDBO targets may be used reducing µDBO target size, thereby saving expensive in-die area.

Further embodiments of the present method, metrology apparatus and metrology target are disclosed in the subsequent list of numbered clauses:

1. A method of measuring an overlay or focus parameter from a target, the method comprising:
configuring measurement radiation to obtain a configured measurement spectrum of said measurement radiation by:

imposing an intensity weighting on individual wavelength bands of said measurement radiation such that said individual wavelength bands have an intensity according to said intensity weighting, the intensity weighting being such that a measured value for the overlay or focus parameter is at least partially corrected for the effect of target imperfections; and/or
imposing a modulation on a measurement spectrum of said measurement radiation;
measuring the target with said configured measurement radiation and capturing resultant scattered radiation from the target; and
determining a value for said overlay or focus parameter from said scattered radiation.

2. A method as defined in clause 1, wherein said configuring step comprises at least said imposing an intensity weighting, and the scattered radiation comprises at least a pair of complementary higher diffraction orders, and wherein the method further comprises:

determining, for each constituent wavelength band within said scattered radiation, an intensity asymmetry metric from a comparison of the intensities between the pair of complementary higher diffraction orders; and
determining the overlay or focus parameter from said intensity asymmetry metrics and said intensity weighting.

3. A method as defined in clause 2, wherein said step of determining the overlay or focus parameter comprises determining the overlay or focus parameter from the sum of the product of each intensity asymmetry metric and its corresponding weight from said intensity weighting.

4. A method as defined in any clause 1 or 2, wherein said measurement step comprises at least a first measurement for one or more of said wavelength bands for which said intensity weighting comprises a positive weight, and a second measurement for one or more of said wavelength bands for which said intensity weighting comprises a negative weight.

5. A method as defined in clause 4, wherein said second measurement is performed with the intensity weighting imposed according to the magnitude of the one or more negative weights; and

said determining a value for said overlay or focus parameter comprises determining a first value from the difference of:

a sum of the product of each intensity asymmetry metric and its corresponding weight from said intensity weighting for said first measurement; and
a sum of the product of each intensity asymmetry metric and its corresponding weight from said intensity weighting for said second measurement.

6. A method as defined in any preceding clause, comprising an initial calibration phase to determine said intensity weighting, said initial calibration phase comprising:

measuring a plurality of calibration targets with measurement radiation within each of said wavelength bands, said plurality of calibration targets comprising a variation in an imposed overlay or focus value for the overlay or focus parameter between at least some of said calibration targets;
determining a calibration asymmetry metric for each of said calibration targets and for each of said wavelength bands from scattered radiation detected during said measuring step;
determining said intensity weighting from said calibration asymmetry metrics and the known imposed overlay or focus values.

7. A method as defined in clause 6, wherein said intensity weighting is determined such that applying the intensity weighting to said calibration asymmetry metrics results in obtaining said known imposed overlay or focus values.

8. A method as defined in clause 6 or 7, wherein the step of determining said intensity weighting is performed using at least one of: a regression, an independent component analysis and a machine learning method.

9. A method as defined in any of clauses 6 to 8, wherein said plurality of calibration targets each comprise a respective different imposed overlay or focus value.

10. A method as defined in any preceding clause, wherein the overlay or focus parameter comprises overlay and said target comprises a single periodic structure per measurement direction.

11. A method as defined in clause 10, wherein said target has no imposed bias.

12. A method as defined in clause 10 or 11, wherein said configuring step comprises at least said imposing a modulation on a measurement spectrum of said measurement radiation; wherein
said modulation is configured to optimize a temporal coherence function of said measurement radiation for said target.

13. A method as defined in clause 12, comprising configuring said modulation so as to optimize a temporal coherence function such that said temporal coherence function comprises at least one visible fringe corresponding with the depth of a layer of interest comprising at least a component of said target.

14. A method as defined in clause 13, wherein said configuring said modulation comprises defining a depth window such that an overlay signal in said scattered radiation relates predominately to said layer of interest

15. A method as defined in clause 14, comprising configuring a shape of the depth window by tuning the shape of the measurement spectrum.

16. A method as defined in any of clauses 12 to 15, wherein said configuring said modulation comprises configuring a modulation frequency of said modulation.

17. A method as defined in any of clauses 12 to 16, wherein said modulation is a sinusoidal or sinusoidal-like modulation.

18. A method as defined in any preceding clause, wherein said step of configuring measurement radiation is performed using an illumination arrangement for spectrally shaping said measurement radiation, by:

dispersing the measurement radiation;
spatially modulating the measurement radiation subsequent to being dispersed using a spatial light modulator; and at least one of:

expanding said measurement radiation in at least one direction, prior to said spatially modulating; and directing a respective wavelength band of the measurement radiation subsequent to being dispersed onto a respective region of the spatial light modulator.

19. A method as defined in clause 18, wherein said measurement radiation is expanded in said at least one direction and control of the spatial modulation controls which wavelength bands are comprised within the configured measurement spectrum and transmission per wavelength band of the configured measurement spectrum.

20. A method as defined in clause 18 or 19, wherein said expanding said measurement radiation comprising expanding the measurement radiation substantially in a first direction; and the direction of dispersal is in a second direction perpendicular to said first direction, such that a first axis of the spatial light modulator controls the spectral components comprised within the configured measurement spectrum and a second axis of the spatial light modulator controls transmission per wavelength band of the configured measurement spectrum.

21. A method as defined in any of clauses 1 to 17, wherein said step of configuring measurement radiation is performed using an acousto-optical tunable filter.

22. A metrology apparatus measuring an overlay or focus parameter from a target, being operable to perform the method of any preceding clause.

23. A metrology apparatus as defined in clause 22, comprising:

an illumination arrangement for configuring said measurement radiation and illuminating the target with said configured measurement radiation;
a sensor arrangement for capturing the scattered radiation; and
a substrate support for supporting a substrate comprising said target.

24. A metrology apparatus as defined in clause 23, wherein said illumination arrangement comprises:

a beam dispersing element for dispersing the measurement radiation;
a spatial light modulator for spatially modulating the measurement radiation subsequent to being dispersed; and at least one of:

a beam expanding element for expanding said measurement radiation in at least one direction, located between an input of the illumination arrangement and the spatial light modulator; and
a lens array, each lens of which for directing a respective wavelength band of the measurement radiation subsequent to being dispersed onto a respective region of the spatial light modulator.

25. A metrology apparatus as defined in clause 24, wherein the illumination arrangement comprises said at least one of said beam expanding elements and control of the spatial light modulator controls which wavelength bands are comprised within the configured measurement spectrum and transmission per wavelength band of the configured measurement spectrum.

26. A metrology apparatus as defined in clause 24 or 25, wherein the beam expanding element comprises a 1 dimensional beam expanding element for expanding the measurement radiation substantially in a first direction; and the direction of dispersal of the beam dispersing element is in a second direction perpendicular to said first direction, such that a first axis of the spatial light modulator controls the spectral components comprised within the configured measurement spectrum and a second axis of the spatial light modulator controls transmission per wavelength band of the configured measurement spectrum.

27. A metrology apparatus as defined in clause 23, wherein said illumination arrangement comprises an acousto-optical tunable filter.

28. A target array comprising a plurality of calibration targets comprising a variation in an imposed overlay or focus value for the overlay or focus parameter between at least some of said calibration targets for use in the method according to any of clauses 1 to 21.

29. A target array comprising a plurality of calibration targets comprising a variation in an imposed overlay or focus value for the overlay or focus parameter between at least some of said calibration targets for use in a metrology apparatus according to any of clauses 22 to 27.

It should be appreciated that, while the description describes the concepts in terms of $\mu$DBO metrology, it is also applicable to other metrology methods such as in-device metrology IDM, which may be based on detection of an angularly resolved spectrum in a pupil plane. The proposed concepts are also applicable to metrology using an optimized coherence metrology tool such as described in WO2021/001102A1, which is incorporated herein by reference. The proposed concepts can also be used in $\mu$DBF (micro-diffraction based focus) metrology.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

The targets or target structures (more generally structures on a substrate) described herein may be metrology targets specifically designed and formed for the purposes of measurement. In other embodiments, properties of interest may be measured on one or more structures which are functional parts of devices formed on the substrate. Many devices have regular, grating-like structures. The terms target, target grating and target structure as used herein do not require that the target has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of measuring an overlay or focus parameter from a target, the method comprising:

    configuring measurement radiation to obtain a configured measurement spectrum of said measurement radiation by:

        imposing an intensity weighting on individual wavelength bands of said measurement radiation such that said individual wavelength bands have an intensity according to said intensity weighting, the intensity weighting being such that a measured value for the overlay or focus parameter is at least partially corrected for the effect of target imperfections; and/or imposing a modulation on a measurement spectrum of said measurement radiation;

    measuring the target with said configured measurement radiation and capturing resultant scattered radiation from the target; and determining a value for said overlay or focus parameter from said scattered radiation.

2. A method as claimed in claim 1, wherein said configuring step comprises at least said imposing an intensity weighting, and the scattered radiation comprises at least a pair of complementary higher diffraction orders, and wherein the method further comprises:

    determining, for each constituent wavelength band within said scattered radiation, an intensity asymmetry metric from a comparison of the intensities between the pair of complementary higher diffraction orders; and determining the overlay or focus parameter from said intensity asymmetry metrics and said intensity weighting.

3. A method as claimed in claim 2, wherein said step of determining the overlay or focus parameter comprises determining the overlay or focus parameter from the sum of the product of each intensity asymmetry metric and its corresponding weight from said intensity weighting.

4. A method as claimed in any claim 1 or 2, wherein said measurement step comprises at least a first measurement for one or more of said wavelength bands for which said intensity weighting comprises a positive weight, and a second measurement for one or more of said wavelength bands for which said intensity weighting comprises a negative weight.

5. A method as claimed in claim 4, wherein said second measurement is performed with the intensity weighting imposed according to the magnitude of the one or more negative weights; and said determining a value for said overlay or focus parameter comprises determining a first value from the difference of:

    a sum of the product of each intensity asymmetry metric and its corresponding weight from said intensity weighting for said first measurement; and a sum of the product of each intensity asymmetry metric and its corresponding weight from said intensity weighting for said second measurement.

6. A method as claimed in any preceding claim, comprising an initial calibration phase to determine said intensity weighting, said initial calibration phase comprising:

    measuring a plurality of calibration targets with measurement radiation within each of said wavelength bands, said plurality of calibration targets comprising a variation in an imposed overlay or focus value for the overlay or focus parameter between at least some of said calibration targets; determining a calibration asymmetry metric for each of said calibration targets and for each of said wavelength bands from scattered radiation detected during said measuring step; determining said intensity weighting from said calibration asymmetry metrics and the known imposed overlay or focus values.

7. A method as claimed in claim 6, wherein said intensity weighting is determined such that applying the intensity weighting to said calibration asymmetry metrics results in obtaining said known imposed overlay or focus values.

8. A method as claimed in any preceding claim, wherein the overlay or focus parameter comprises overlay and said target comprises a single periodic structure per measurement direction.

9. A method as claimed in claim 8, wherein said target has no imposed bias.

10. A metrology apparatus measuring an overlay or focus parameter from a target, being operable to perform the method of any preceding claim.

11. A metrology apparatus as claimed in claim 10, comprising:

an illumination arrangement for configuring said measurement radiation and illuminating the target with said configured measurement radiation;
a sensor arrangement for capturing the scattered radiation; and
a substrate support for supporting a substrate comprising said target.

12. A metrology apparatus as claimed in claim 11, wherein said illumination arrangement comprises:

a beam dispersing element for dispersing the measurement radiation;
a spatial light modulator for spatially modulating the measurement radiation subsequent to being dispersed; and at least one of:

a beam expanding element for expanding said measurement radiation in at least one direction, located between an input of the illumination arrangement and the spatial light modulator; and
a lens array, each lens of which for directing a respective wavelength band of the measurement radiation subsequent to being dispersed onto a respective region of the spatial light modulator.

13. A metrology apparatus as claimed in claim 12, wherein the illumination arrangement comprises said at least one of said beam expanding elements and control of the spatial light modulator controls which wavelength bands are comprised within the configured measurement spectrum and transmission per wavelength band of the configured measurement spectrum.

14. A target array comprising a plurality of calibration targets comprising a variation in an imposed overlay or focus value for the overlay or focus parameter between at least some of said calibration targets for use in the method according to any of claims 1 to 9.

15. A target array comprising a plurality of calibration targets comprising a variation in an imposed overlay or focus value for the overlay or focus parameter between at least some of said calibration targets for use in a metrology apparatus according to any of claims 10 to 13.

Fig. 1

Fig. 2

Fig. 3

Fig. 4

Fig. 5

Fig. 6

Fig. 7

Fig. 8

Fig. 9

Europäisches
Patentamt

European
Patent Office

Office européen
des brevets

# EUROPEAN SEARCH REPORT

Application Number

EP 21 21 0123

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2021/001102 A1 (ASML NETHERLANDS BV [NL]) 7 January 2021 (2021-01-07) * paragraphs [0047], [0055] – [0058], [0060], [0063] – [0066], [0069], [0075]; claims 1,10,15; figures 4,8-10 * | 1-15 | INV. G03F7/20 |
| X | US 2021/263432 A1 (IWAI TOSHIKI [JP] ET AL) 26 August 2021 (2021-08-26) | 1-3,8-11 | |
| A | * paragraphs [0001], [0006] – [0009], [0047], [0077] – [0081], [0085], [0092], [0116]; claims 1,2,16 * | 4-7, 12-15 | |
| X | US 2009/284744 A1 (MIEHER WALTER D [US] ET AL) 19 November 2009 (2009-11-19) | 14,15 | |
| A | * paragraphs [0105], [0106], [0219] – [0223]; figures 5B,11a-11c * | 10-13 | |
| X | WO 2020/057900 A1 (ASML NETHERLANDS BV [NL]) 26 March 2020 (2020-03-26) | 14,15 | |
| A | * paragraphs [0080] – [0087], [0096] * | 1-13 | |

TECHNICAL FIELDS SEARCHED (IPC)

G03F

The present search report has been drawn up for all claims

| Place of search | Date of completion of the search | Examiner |
|---|---|---|
| Munich | 11 May 2022 | Roesch, Guillaume |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

**EP 21 21 0123**

This annex lists the patent family members relating to the patent documents cited in the above-mentioned European search report.
The members are as contained in the European Patent Office EDP file on
The European Patent Office is in no way liable for these particulars which are merely given for the purpose of information.

**11-05-2022**

| Patent document cited in search report | Publication date | Patent family member(s) | | Publication date |
|---|---|---|---|---|
| WO 2021001102 A1 | 07-01-2021 | CN | 114008534 A | 01-02-2022 |
| | | EP | 3994523 A1 | 11-05-2022 |
| | | KR | 20220016950 A | 10-02-2022 |
| | | TW | 202105079 A | 01-02-2021 |
| | | US | 2022121128 A1 | 21-04-2022 |
| | | WO | 2021001102 A1 | 07-01-2021 |
| US 2021263432 A1 | 26-08-2021 | JP | 2021131348 A | 09-09-2021 |
| | | KR | 20210106903 A | 31-08-2021 |
| | | US | 2021263432 A1 | 26-08-2021 |
| US 2009284744 A1 | 19-11-2009 | AT | 504862 T | 15-04-2011 |
| | | EP | 1601931 A2 | 07-12-2005 |
| | | JP | 4789798 B2 | 12-10-2011 |
| | | JP | 4932949 B2 | 16-05-2012 |
| | | JP | 5280507 B2 | 04-09-2013 |
| | | JP | 5469688 B2 | 16-04-2014 |
| | | JP | 5675936 B2 | 25-02-2015 |
| | | JP | 6553145 B2 | 31-07-2019 |
| | | JP | 6668533 B2 | 18-03-2020 |
| | | JP | 2006518942 A | 17-08-2006 |
| | | JP | 2011155302 A | 11-08-2011 |
| | | JP | 2012032408 A | 16-02-2012 |
| | | JP | 2012089896 A | 10-05-2012 |
| | | JP | 2014042069 A | 06-03-2014 |
| | | JP | 2015052602 A | 19-03-2015 |
| | | JP | 2016106269 A | 16-06-2016 |
| | | JP | 2017227934 A | 28-12-2017 |
| | | JP | 2019091094 A | 13-06-2019 |
| | | US | 2004169861 A1 | 02-09-2004 |
| | | US | 2004233439 A1 | 25-11-2004 |
| | | US | 2004233440 A1 | 25-11-2004 |
| | | US | 2004233441 A1 | 25-11-2004 |
| | | US | 2004233442 A1 | 25-11-2004 |
| | | US | 2004233443 A1 | 25-11-2004 |
| | | US | 2004233444 A1 | 25-11-2004 |
| | | US | 2004257571 A1 | 23-12-2004 |
| | | US | 2008024766 A1 | 31-01-2008 |
| | | US | 2008049226 A1 | 28-02-2008 |
| | | US | 2008094630 A1 | 24-04-2008 |
| | | US | 2009284744 A1 | 19-11-2009 |
| | | US | 2010091284 A1 | 15-04-2010 |
| | | WO | 2004076963 A2 | 10-09-2004 |
| WO 2020057900 A1 | 26-03-2020 | CN | 112740109 A | 30-04-2021 |
| | | EP | 3853666 A1 | 28-07-2021 |

EPO FORM P0459

For more details about this annex : see Official Journal of the European Patent Office, No. 12/82

**page 1 of 2**

**ANNEX TO THE EUROPEAN SEARCH REPORT
ON EUROPEAN PATENT APPLICATION NO.**                      EP 21 21 0123

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2022

| Patent document cited in search report | Publication date | Patent family member(s) | | Publication date |
|---|---|---|---|---|
| | | JP | 2022500685 A | 04-01-2022 |
| | | KR | 20210043661 A | 21-04-2021 |
| | | NL | 2023709 A | 30-04-2020 |
| | | TW | 202028874 A | 01-08-2020 |
| | | US | 2022035257 A1 | 03-02-2022 |
| | | WO | 2020057900 A1 | 26-03-2020 |

EPO FORM P0459

For more details about this annex : see Official Journal of the European Patent Office, No. 12/82

page 2 of 2

**REFERENCES CITED IN THE DESCRIPTION**

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B

- WO 2011012624 A
- US 20160161863 A
- US 20160370717 A1
- US 2006033921 A1
- US 2010201963 A1
- US 2006066855 A1
- WO 2009078708 A
- WO 2009106279 A
- US 20110027704 A
- US 20110043791 A
- US 20120123581 A
- US 20130258310 A
- US 20130271740 A
- WO 2013178422 A1
- WO 2021001102 A
- WO 2021001102 A1